(19) Europäisches Patentamt
European Patent Office
Office européen des brevets

(11) Veröffentlichungsnummer: **0 106 990**
**A1**

# (12) EUROPÄISCHE PATENTANMELDUNG

(21) Anmeldenummer: 83108671.5

(22) Anmeldetag: 02.09.83

(51) Int. Cl.³: **H 05 K 3/36**, H 01 R 23/72

(30) Priorität: 23.09.82 DE 3235212

(43) Veröffentlichungstag der Anmeldung: 02.05.84 Patentblatt 84/18

(84) Benannte Vertragsstaaten: AT BE CH DE FR GB IT LI NL SE

(71) Anmelder: Schoeller & Co. Elektronik GmbH, Marburger Strasse, D-3552 Wetter/Hessen (DE)

(72) Erfinder: Gliem, Ralf, Dipl.-Ing., Mörikeweg 1, D-3552 Wetter/Hessen (DE)

(74) Vertreter: Nowak, Gerhard, DEGUSSA AG Fachbereich Patente Postfach 1345, D-6450 Hanau 1 (DE)

## (54) Kontaktierungselement für Gedruckte Schaltungen.

(57) Es wird ein Kontaktierungselement (6) zum elektrischen Verbinden von Gedruckten Schaltungen (1, 9) mittels einer Anpreßverbindung beschrieben. Die durch eine Schutzfolie (5) abgedeckten Leiterbahnen (3) enden in kongruent angeordneten Kontaktflächen (4). Das Kontaktierungselement (6) besteht aus einer dünnen Trägerfolie (7) aus einem elektrisch isolierenden Material, in der durchgehende Kontakte (9) eingebracht sind, entsprechend den Kontaktflächenmustern auf den Gedruckten Schaltungen, wobei die Kontakte (8) die Trägerfolie (7) beidseitig überragen. Vorzugsweise besteht das Kontaktierungselement (6) aus einer Gedruckten Schaltung mit durchkontaktierten Bohrungen.

11
9
13
10
12
6
7
8
4
5
1
2
3

EP 0 106 990 A1

0106990

82 173 VT

Schoeller & Co. Elektronik GmbH

3552 Wetter/Hessen, Marburger Straße

Kontaktierungselement für Gedruckte Schaltungen

Die Erfindung betrifft ein Kontaktierungselement zum elektrischen Verbinden der Leiterbahnen von zwei Gedruckten Schaltungen mittels einer Anpressverbindung, wobei die mit einer isolierenden Schicht abgedeckten Leiterbahnen am Rande der beiden Gedruckten Schaltungen in Kontaktflächen enden und die Kontaktflächen jeweils in kongruenten Mustern angeordent sind. Vorzugsweise ist eine der zu verbindenden Gedruckten Schaltungen eine flexible Gedruckte Schaltung, wobei man zwei starre Gedruckte Schaltungen auch unter Zwischenschaltung einer flexiblen Gedruckten Schaltung miteinander verbinden kann. Die Gedruckten Schaltungen können dabei jeweils ein-, zwei- oder mehrlagig sein.

Nahezu alle elektronischen Geräte werden heute auf der Basis von Gedruckten Schaltungen (Leiterplatten) aufgebaut. Bei größeren Systemen ist es jedoch aus technischen und wirtschaftlichen Gründen nicht möglich, alle elektronischen Komponenten auf einer sehr großflächigen Leiterplatte aufzubauen. Stattdessen wird eine Vielzahl von kleineren Leiterplatten verwendet, zwischen denen dann allerdings elektrische Verbindungen hergestellt werden müssen. Diese Grundaufgabe der Elektronik wird auf vielfältige Weise gelöst, zum Beispiel durch Verbindungsdrähte oder Kabel, die an vorbereiteten Stellen in die Gedruckten Schaltungen eingelötet werden, durch Steckverbinder, die auf die Gedruckten Schaltungen aufgesteckt werden und deren Anschlußstifte mittels Drähten, Kabeln oder durch andere Gedruckte Schaltungen (sogenannte Motherboards oder Back Panels) elektrisch verbunden werden, oder durch Anpressverbinder, bei denen besonders vorbereitete Teile der Gedruckten Schaltungen in direktem Kontakt zueinander gebracht und durch geeignete mechanische Elemente federnd aufeinandergepreßt werden.

Diese elektrischen Verbindungssysteme müssen eine Reihe von Voraussetzungen und Anforderungen erfüllen. Sie müssen eine hohe Zuverlässigkeit aufweisen, der Übergangswiderstand muß möglichst gering sein und sie müssen einen ausreichenden Schutz gegen korrodierende Umwelteinflüsse erbringen. Wegen der Miniaturisierung muß eine hohe Kontaktdichte pro Flächeneinheit erzielbar sein, bei möglichst geringen Einzelkontaktkosten.

Die rasche Entwicklung der Integrierten Schaltungen hat zu neuen Entwicklungszwängen für die elektrischen Verbindungen zwischen den Gedruckten Schaltungen geführt, denn diese konnten in den letzten Jahren bezüglich Zuverlässigkeit, Miniaturisierung und Kostensenkung der Entwicklung der Integrierten Schaltungen nicht folgen. Sie gelten daher heute als kostspieliger und technisch schwacher Punkt eines elektronischen Systems.

Bisher wurde das Hauptgewicht darauf gelegt, die klassischen Steckverbindungen zwischen den Gedruckten Schaltungen zu verbessern. Hier stößt man bei der Miniaturisierung und der Zahl der anzubringenden Verbindungen aber bald an eine Grenze, die man nur schwer überschreiten kann.

Bekannt sind auch elektrische Verbindungen des Types "Anpressverbindung". In ihrer primitivsten Form ist die Anpressverbindung in der Elektrotechnik weit verbreitet, zum Beispiel durch Zusammendrücken zweier Drähte mittels einer Schraube in einer Lüsterklemme. Die Übertragung dieses Verbindungsprizips auf Gedruckte Schaltungen ist mit einigen Abwandlungen möglich. Dabei werden die Kontaktflächen der Leiterbahnen, meist an den Enden der Gedruckten Schaltungen, miteinander in Berührung gebracht und mittels elastischer Zwischenelemente und Anpressplatten die elektrische Verbindung hergestellt.

Bei gegebener Größe der Gedruckten Schaltung läßt sich die Kontaktdichte zunächst dadurch erhöhen, daß die Kontaktflächen verkleinert werden. Gleichzeitig sinken dabei die Kosten pro Kontakt, da diese aufgrund der üblichen Herstellverfahren der Gedruckten Schaltungen nur von der Gesamtkontaktfläche nicht jedoch von der Anzahl der Kontakte abhängig sind. Leider verschlechtern sich mit abnehmender Kontaktfläche jedoch die elektrischen Eigenschaften des Verbindungssystems: Der Übergangswiderstand wird größer, schließlich treten durch unvermeidliche Toleranzen bei der Justierung der Kontaktflächen zueinander Kurzschlüsse auf. Da es aus konstruktiven Gründen meist unmöglich ist alle Kanten der Gedruckten Schaltungen mit elektrischen Verbindungen zu belegen, bleibt somit nur die Anordnung weiterer Kontaktflächen auf der Innenfläche der Gedruckten Schaltung.

Konstruktive Zwänge verbieten wiederum, dies an beliebiger Stelle zu tun. Stattdessen ist eine Anordnung in unmittelbarer Nähe der ersten Kontaktreihe naheliegend. Es ist leicht einzusehen, daß ab einer bestimmten Kontaktdichte und Kontaktanzahl die von den Kontaktflächen wegführenden Leiterbahnen nicht mehr so gelegt werden können, daß mit den Leiterbahnen des Gegenstückes keine unerwünschten Kontakte (Kurzschlüsse) entstehen können.

Diese Nachteile können vermieden werden, wenn man mittels

0106990

bekannter Verfahren die Leiterbahnen, nicht jedoch die Kontaktflächen, mit einer isolierenden Schicht (Folie oder Lacke) versieht. Damit liegen jedoch die Kontaktflächen unter dem Oberflächenniveau der Gedruckten Schaltung und können dementsprechend nicht mehr ohne weiteres mit den Kontaktflächen des Gegenstückes in Berührung kommen.

Es sind Verfahren bekannt, mittels derer die Kontaktflächen soweit verstärkt werden, daß sie über das Niveau der Isolierschicht hinausragen und so wieder eine sichere Kontaktierung gewährleisten. Dies kann beispielsweise erreicht werden, indem man eine Kupferkaschierung des Basismaterials wählt, die mindestens um soviel stärker als die für das Leiterbild benötigte Stärke ist wie die Stärke der Isolierschicht beträgt. Mittels bekannter Verfahren werden nun zunächst die Kontaktflächen mit einem Ätzresist versehen und danach der restliche Bereich, der später das Leiterbild trägt, auf die gewünschte Stärke für das Leiterbild abgeätzt. Nach diesem Verfahrensschritt sind die Kontaktflächen somit um mindestens die Stärke der Isolierschicht gegenüber dem Leiterbild erhöht. Die weiteren Schritte zur Herstellung des Leiterbildes und zur Aufbringung der Isolierschicht geschehen in bekannter Weise.

Dieses Verfahren zur Erzeugung erhöhter Kontaktflächen hat jedoch erhebliche Nachteile. So sind gegenüber der Herstellung einer üblichen Gedruckten Schaltung zwei zusätzliche, kostspielige Prozeßschritte notwendig (Ätzresist aufbringen, Ätzen). Außerdem kann der Ätzvorgang selbst bei Anwendung modernster Maschinen nicht so genau kontrolliert werden, daß die Schichtstärke des übrigbleibenden Kupfers überall gleich ist. Dementsprechend haben auch die späteren Leiterbahnen unterschiedliche Stärke, was insbesondere bei sehr dünnen Leiterbahnen (zum Beispiel bei flexiblen Schaltungen) nicht akzeptabel ist. Weiterhin behindern die erhöhten Kontaktflächen die nachfolgende Herstellung des Leiterbildes beim Aufbringen des Galvanik- oder Ätzresists. Die Herstellung feiner Strukturen mit hoher Kontaktdichte ist auf diese Weise nicht möglich, da infolge der erhöhten Kontaktflächen die korrekte Aufbringung eines Photoresists und das notwendige Belichten im Kontaktverfahren nicht durchführbar ist.

Bei einem anderen bekannten Verfahren (US-PS 4 125 310) wird die notwendige Erhöhung der Kontaktflächen mittels eines galvanischen Prozesses erreicht. In unterschiedlichen Stadien der Herstellung wird dazu die gesamte Schaltung, mit Ausnahme der Kontaktflächen, mittels Galvanoresist abgedeckt und die Kontaktflächen selektiv galvanisch verstärkt. Aber auch dieses Verfahren hat erhebliche Nachteile, indem gegenüber der Herstellung einer üblichen Gedruckten Schaltung auch hier mindestens zwei kostspielige Fertigungsschritte zusätzlich notwendig sind und das Aufgalvanisieren relativ dicker Schichten ( $\geq$ 20 um) zwangsläufig zu einer unebenen Oberfläche der Kontakte und damit zu unsicherer Kontaktgabe führt.

Es war daher Aufgabe der vorliegenden Erfindung, ein Kontaktierungselement zum elektrischen Verbinden der Leiterbahnen von zwei Gedruckten Schaltungen mittels einer Anpressverbindung zu schaffen, wobei die mit einer isolierenden Schicht abgedeckten Leiterbahnen am Rand der beiden Gedruckten Schaltungen in Kontaktflächen enden und die Kontaktflächen jeweils in kongruenten Mustern angeordnet sind. Dabei sollten keine zusätzlichen Prozesschritte und damit keine Mehrkosten erforderlich werden, eine hohe Kontaktdichte je Flächeneinheit erzielbar und die Zahl der Kontakte in beliebiger Größe herstellbar sein, bei gleichzeitiger Erreichung einer hohen Zuverlässigkeit.

Diese Aufgabe wurde erfindungsgemäß dadurch gelöst, daß das Kontaktierungselement aus einer dünnen Trägerfolie aus einem elektrisch isolierenden Material besteht, in der, entsprechend den kongruenten Anordnungen der Kontaktflächen auf den zu verbindenden Gedruckten Schaltungen, durchgehende Kontakte aus elektrisch leitendem Material eingebracht sind, deren Kontaktflächen in ihrer Größe mit den Kontaktflächen der Leiterbahnen übereinstimmen und die die Trägerfolie beidseitig überragen.

Das Kontaktierungselement besteht aus einem Isoliermaterial und den darin eingebetteten Kontakten. Die Kontakte sind in der Trägerfolie so angeordnet, daß sich an jeder Stelle der beiden Gedruckten Schaltungen, an der eine elektrische Verbindung entstehen soll, genau ein Kontakt befindet. Die Kontakte haben eine sehr einfache geometrische Form, beispielsweise Stifte oder Hülsen mit rundem oder beliebigem anderem Querschnitt, und überbrücken den Abstand zwischen den hinter den Isolierschichten zurückliegenden Kontaktflächen der Leiterbahnen der beiden Gedruckten Schaltungen. Die Kontaktflächen der Kontakte sind gleich groß wie die Kontaktflächen der Leiterbahnen oder geringfügig kleiner. Sie überragen die Trägerfolie dabei mindestens um die Dicke der Isolierschicht, mit der die Leiterbahnen abgedeckt sind. Die Kontakte können mit bekannten Verfahren hergestellt werden und auf bekannte Weise, zum Beispiel Nieten, Einpressen oder Kleben, in die Trägerfolie eingebracht werden.

Als besonders vorteilhaft hat sich die Verwendung einer Gedruckten Schaltung mit durchkontaktierten Bohrungen als Kontaktierungselement erwiesen. Die nach bekannten Verfahren hergestellten Hülsen der durchkontaktierten Bohrung dienen hierbei als Kontakte.

Die Trägerfolie des Kontaktierungselementes besteht vorzugsweise aus hinreichend flexiblem Material, um eventuelle Niveauunterschiede der Kontaktflächen auszugleichen. Der hierzu notwendige Anpressdruck wird in bekannter Weise durch eine federnde Zwischenlage, zum Beispiel Gummistreifen, und einfache mechanische Druckkörper erzeugt. Die Trägerfolie besteht beispielsweise aus Polyimiden oder glasfaserverstärkten Epoxydharzen. Eine Dicke von 0,05 - 1 mm hat sich als vorteilhaft erwiesen.

Die Abbildungen I und II zeigen schematisch eine Anpressverbindung zwischen zwei Gedruckten Schaltungen mit einem erfindungsgemäßen Kontaktierungselement in beispielhafter Ausführungsform. Abbildung I gibt dabei eine perspektivische Darstellung und Abbildung II einen Längsschnitt wieder.

Eine starre Gedruckte Schaltung (1), bestehend aus einer Leiterplatte (2) und den Leiterbahnen (3), die in Kontaktflächen (4) am Rand der Leiterplatte (2) enden und - mit Ausnahme der Kontaktflächen (4) - mit einer Schutzfolie (5) oder einem Schutzlack überzogen sind, wird über das Kontaktierungselement (6), bestehend aus einer flexiblen Trägerfolie (7) und Kontakten (8) mit einer flexiblen Gedruckten Schaltung (9) verbunden, die analog der starren Gedruckten Schaltung (1) aus Trägermaterial (10), Leiterbahnen (11), Kontaktflächen (12) und Schutzfolie (13) sich zusammensetzt. Die Anpreßverbindung erfolgt über Druckplatten (14) und elastischen Zwischenlagen (15), von denen in Abbildung II nur jeweils eine eingezeichnet sind. Die jeweiligen Kontaktflächen (4, 12) auf den beiden Gedruckten Schaltungen (1, 10) müssen geometrisch so angeordnet sein, daß sie beim Aufeinanderlegen übereinstimmen, also kongruent sind. Dementsprechend muß auch die Anordnung der Kontakte (8) des Kontaktierungselements (6) ausgeführt sein, das in vorliegenden Falle ebenfalls als Gedruckte Schaltung mit durchkontaktierten Bohrungen vorliegt.

Mit dem erfindungsgemäßen Kontaktierungselement lassen sich komplette Magazin-Verdrahtungen mit hoher Verdrahtungsdichte unter völligem Verzicht auf konventionelle Steckverbinder und Drähte aufbauen.

Die erzielbare Kontaktdichte übertrifft dabei bei weitem die mit konventionellen Steckverbindern erzielbare. Während zum Beispiel bisher an einer 10 cm breiten Leiterplatte bestenfalls ein Stecker mit 96 Kontakten angeordnet werden konnte lassen sich mit dem Kontaktierungselement bei Anordnung der Kontakte in 4 Reihen auf beiden Seiten leicht insgesamt 256 Kontakte und damit nach außen zu weiteren Leiterplatten oder sonstigen elektrischen Baugruppen führende Verbindungen schaffen. Im Gegensatz zur konventionellen Steckverbindung sinken dabei die Kosten je Verbindung mit zunehmender Kontaktzahl.

Eine solche hohe Kontaktdichte bei niedrigeren Kosten je Kontakt und hoher Zuverlässigkeit ist besonders bei Mehrlagenleiterplatten und in Verbindung mit hochintegrierten Halbleitern in Chip-Carrier-Gehäuse erforderlich.

Schoeller & Co. Elektronik GmbH

3552 Wetter/Hessen, Marburger Straße

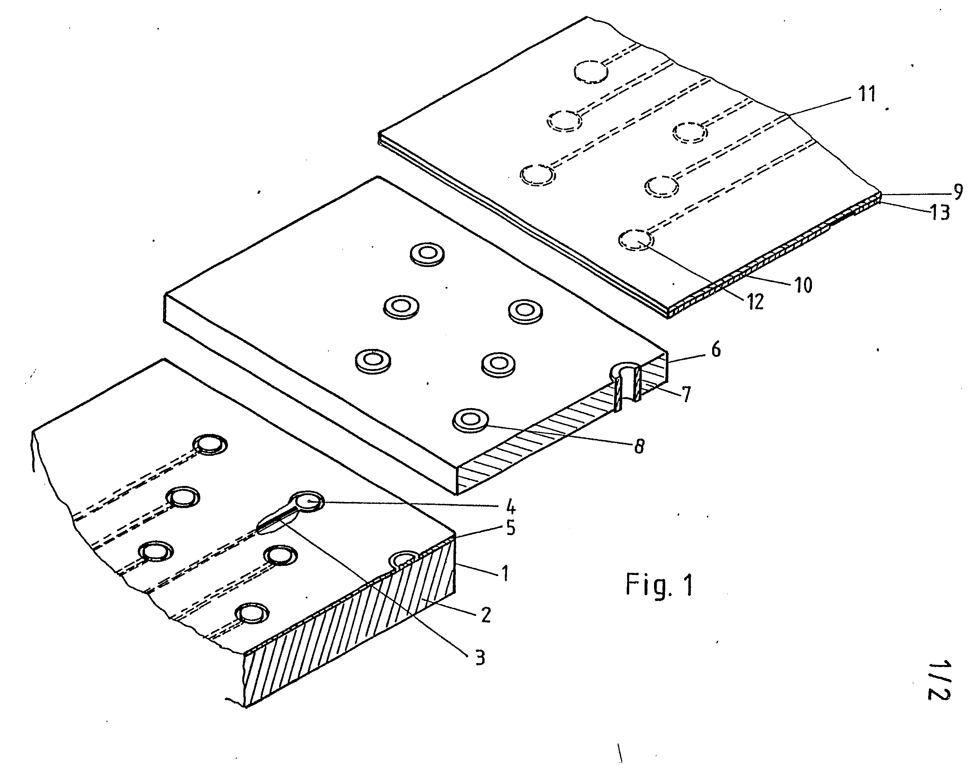

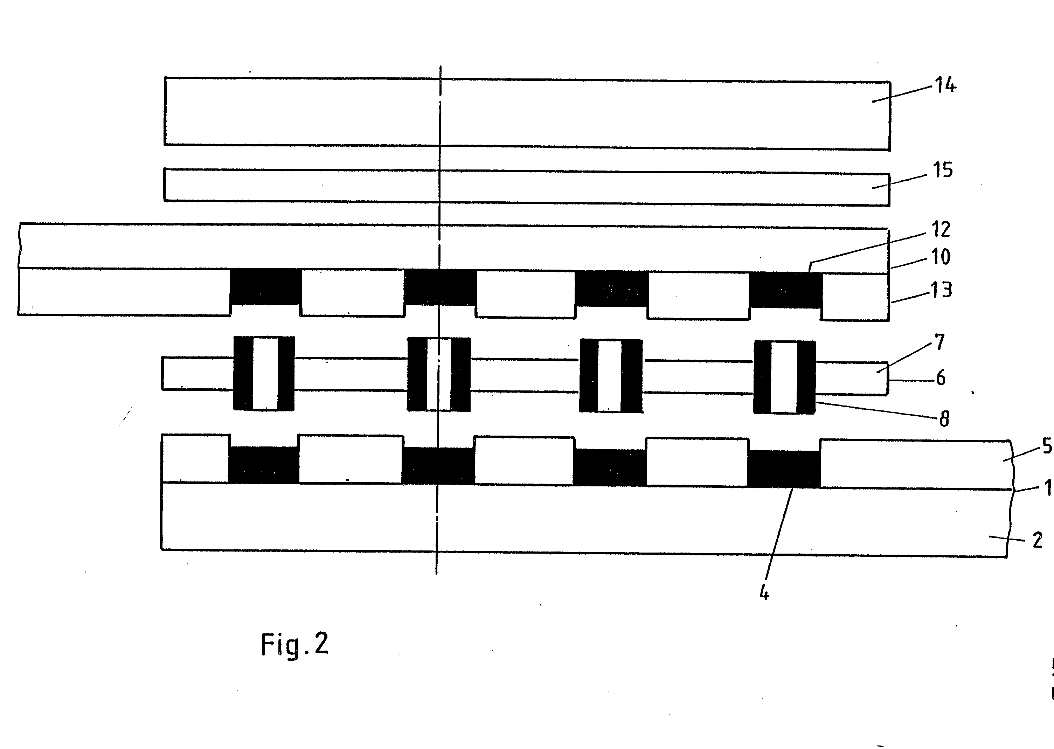

**Patentansprüche**

1. Kontaktierungselement zum elektrischen Verbinden der Leiterbahnen von zwei Gedruckten Schaltungen mittels einer Anpressverbindung, wobei die mit einer isolierenden Schicht abgedeckten Leiterbahnen am Rand der beiden Gedruckten Schaltungen in Kontaktflächen enden und die Kontaktflächen jeweils in kongruenten Mustern angeordnet sind, dadurch gekennzeichnet, daß es aus einer dünnen Trägerfolie (7) aus einem elektrisch isolierenden Material besteht, in der entsprechend den kongruenten Anordnungen der Kontaktflächen (4, 12) auf den zu verbindenden Gedruckten Schaltungen (1, 9), durchgehende Kontakte (8) aus elektrisch leitendem Material eingebracht sind, deren Kontaktflächen in ihrer Größe mit den Kontaktflächen (4, 12) der Leiterbahnen (3, 11)übereinstimmen und die die Trägerfolie (7) beidseitig überragen.

2. Kontaktierungselement nach Anspruch 1, dadurch gekennzeichnet, daß die Trägerfolie (7) eine Dicke von 0,05 bis 1 mm besitzt.

3. Kontaktierungselement nach Anspruch 1 und 2, dadurch gekennzeichnet, daß die Trägerfolie (7) flexibel ist.

4. Kontaktierungselement nach Anspruch 1 bis 3, <u>dadurch gekennzeichnet</u>, daß es aus einer Gedruckten Schaltung mit durchkontaktierten Bohrungen besteht.

Fig. 1

Fig. 2

Europäisches Patentamt

# EUROPÄISCHER RECHERCHENBERICHT

0106990 Nummer der Anmeldung

EP 83 10 8671

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. 3) |
|---|---|---|---|
| | | | H 05 K 3/36 |
| X | US-A-4 268 956 (PARKS et al.) * Spalte 2, Zeilen 25-64; Spalte 3, Zeile 23 - Spalte 4, Zeile 19; Figuren 2, 2A, 5 * | 1-4 | H 01 R 23/72 |
| | --- | | |
| A | DE-A-3 008 110 (SHIN-ETSU) * Anspruch 1; Seite 4, Zeilen 1-19; Seite 5, Zeile 32 - Seite 6, Zeile 8; Seite 13, Zeile 12 - Seite 15, Zeile 32; Figuren 1-5 * | 1,3 | |
| | --- | | |
| A | DE-A-3 030 312 (GOULD) * Ansprüche 1, 2, 10; Seite 11, Zeile 20 - Seite 12, Zeile 13; Figuren 1-10 * | 1 | |
| | ----- | | |
| | | | RECHERCHIERTE SACHGEBIETE (Int. Cl. 3) |
| | | | H 01 R 23/66 |
| | | | H 01 R 23/72 |
| | | | H 05 K 3/36 |

Der vorliegende Recherchenbericht wurde für alle Patentansprüche erstellt.

| Recherchenort | Abschlußdatum der Recherche | Prüfer |
|---|---|---|
| BERLIN | 16-12-1983 | HAHN G |

KATEGORIE DER GENANNTEN DOKUMENTEN

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82